**Europäisches Patentamt**

**European Patent Office**

**Office européen des brevets**

(19)

(11) Veröffentlichungsnummer: **0 233 950**
**A1**

(12) **EUROPÄISCHE PATENTANMELDUNG**
Veröffentlicht nach Art. 158 Abs. 3 EPÜ

(21) Anmeldenummer: 86905484.1

(22) Anmeldetag: 06.08.86

(51) Int. Cl.³: **C 30 B 15/30**
**C 30 B 15/00**

Daten der zugrundeliegenden internationalen Anmeldung:

(86) Internationale Anmeldenummer:
PCT/SU86/00076

(87) Internationale Veröffentlichungsnummer:
WO87/00870 (12.02.87 87/04)

AUF GRUND VON PLATZMANGEL WERDEN DIE NACH-
FOLGEND AUFGEFÜHRTEN ERFINDER OHNE ANSCHRIFT
ERWÄHNT: GEORGIEV, KHRISTO TODOROV; SHISHKOV,
GEORGI VLADIMIROV; MAREV, KRASTIU VALCHEV;
ATLARSKI,N.K;ALEXIEV, P.

(30) Priorität: 09.08.85 SU 3946561

(43) Veröffentlichungstag der Anmeldung:
02.09.87 Patentblatt 87/36

(84) Benannte Vertragsstaaten:
BE CH DE FR IT LI NL

(71) Anmelder: INSTITUT FIZIKI TVERDOGO TELA AKADEMII
NAUK SSSR
Moskovskaya obl.
p/o Chernogolovka, 142432(SU)

(71) Anmelder: NAUCHNO-PROIZVODSTVENNOE PRE-
DPRIYATIE OPTIKA I LAZERNAYA TEKHNIKA
Ul. Kavala 20
Plovdiv(BG)

(72) Erfinder: OSIPIAN, Jury Andreevich
Leninsky pr., 13-22
Moscow, 117071(SU)

(72) Erfinder: TATARCHENKO, Vitaly Antonovich
Dmitrovskoe shosse, 51-1-23
Moscow, 127238(SU)

(72) Erfinder: KOZIN, Nikolai Illarionovich
ul. Bredova, 50-6 Murmanskaya obl.
Apatity, 184200(SU)

(72) Erfinder: MEDKO, Georgy Semenovich
ul. Tsentralnaya, 12-33 Moskovskaya obl.
p/o Chernogolovka, 142432(SU)

(72) Erfinder: AVRUTIK, Alexandr Moiseevich
deceased(SU)

(72) Erfinder: ROSSOLENKO, Sergei Nikolaevich
ul. Tsentralnaya, 4-6 Moskovskaya obl.
p/o Chernogolovka, 142432(SU)

(72) Erfinder: REDKIN, Boris Sergeevich
pr. Stroitelei, 2-109 Moskovskaya obl.
p/o Chernogolovka, 142432(SU)

(72) Erfinder: KURLOV, Vladimir Nikolaevich
Shkolny bulvar, 1b-22 Moskovskaya obl.
p/o Chernogolovka, 142432(SU)

(72) Erfinder: STOLYAROV, Sergei Ivanovich
Institutsky pr., 8-99 Moskovskaya obl.
p/o Chernogolovka, 142432(SU)

(54) ANORDNUNG ZUR ZUCHT VON MONOKRISTALLEN FEUERFESTER METALLOXYYDE AUS DER SCHMELZE

(57) In der erfindungsgemäßen Vorrichtungi ist die Wachstumskammer (5) durch ihren unteren Teil mittels einer Stütze
(6) mit einer Stützplatte (1) starr verbunden, wobei der Ständer (2) mit einer Tragsäule (3), die Konsole (4), die Wachstumskammer (5), die Stütze (6) und die Stützplatte (1) ein geschlossenes steifes System vom "Rahmen"-Typ bilden.

EP 0 233 950 A1

./...

(72) Erfinder: BORODIN, Vladimir Alexeevich
ul. Tsentralnaya, 4v-9 Moskovskaya obl.
p/o Chernogolovka, 142432(SU)

(72) Erfinder: YALOVETS, Tatyana Ivanovna
Institutsky pr., 4-36 Moskovskaya
obl. p/o Chernogolovka, 142432(SU)

(72) Erfinder: TRIFONOV, Alexandar Petrov
ul. Nikala Kamenov
254 V-45, Sofia(BG)

(72) Erfinder: TOPCHIISKI, Ivan Asenov
ul. Komsomolska
27 V. Plovdiv(BG)

(72) Erfinder: VELKOV, Raicho Dimitrov
Zh.R.Trakia, 3 V-7
Plovdiv(BG)

(72) Erfinder: SHOPOVA, Nedka Dimitrova
ul. Kapitan Raicho
55, Plovdiv(BG)

(72) Erfinder: KARARIZOV, Ivan Tomov
Zh.K.Druzhba, 89
Sofia(BG)

(72) Erfinder: BONCHEV, Paskal Boyanov
Bulvar Malchika, 44
Plovdiv(BG)

(72) Erfinder: LATEV, Nedyalko Latev
ul. Krushevo, 4
Plovdiv(BG)

(72) Erfinder: MIKHAILOV, Stefan Biserov
ul. Todor Kableshkov, 2
Plovdiv(BG)

(74) Vertreter: Finck, Dieter et al,
Patentanwälte v. Füner, Ebbinghaus, Finck Mariahilfplatz
2 & 3
D-8000 München, 90(DE)

# VORRICHTUNG ZUR ZÜCHTUNG DER EINKRISTALLE VON HOCHSCHMELZENDEN METALLOXIDEN AUS DER SCHMELZE

## Gebiet der Technik

Die Erfindung bezieht sich auf Vorrichtungen zur Züchtung von Kristallen und betrifft insbesondere Vorrichtungen zur Züchtung der Einkristalle von hochschmelzenden Metalloxiden aus der Schmelze, z.B. zur Züchtung der Einkristalle von Lithiumniobat, Lithiumtantalat, Yttriumtongranat, Saphir, Rubin und anderen Stoffen.

## Bisheriger Stand der Technik

Es ist eine Vorrichtung zur Züchtung der Einkristalle von hochschmelzenden Metalloxiden im Tiegelziehverfahren nach *Chokhralsky* bekannt, (US-PS Nr. 3865554, Klasse B 01 j 17/18, bekanntgemacht 1975), die eine hermetisch abgeschlossene Wachstumskammer enthält, in der ein Schmelzentiegel, ein Impfkristallhalter, ein Induktor, ein System zur Wärmeisolierung des Tiegels und des zu züchtenden Kristalle angeordnet sind.

In die Kammer dieser Vorrichtung sind wassergekühlte eine obere und eine untere Stangen eingeführt, die mit Vorrichtungen zur Drehung und Bewegung der Stangen relativ zu der Wachstumskammer versehen sind. Die Vorrichtungen zur Drehung und Bewegung der Stangen sind im Oberteil der Kammer angeordnet, während die Kammer selbst auf einem Stütztisch befestigt ist. Eine solche Befestigung der Kammer und die Beschwerung des Oberteils derselben durch die Vorrichtungen zur Bewegung und Drehung der Stangen führen zu erhöhten Schwingungen des zu ziehenden Kristalls, wodurch die Qualität des herzustellenden Kristalls verschlechtert und zusätzliche Schwierigkeiten bei der Fertigung der Anlage geschaffen werden, weil die Höhe eines der Zahnräder zur Drehung der Stange mindestens nicht kleiner als die Länge des Stangenhubes sein muß.

Es ist auch eine Vorrichtung zur Züchtung der Kristalle von hochschmelzenden Metalloxiden bekannt (Prospekt

0233950

der französischen Firma LPA "Galaxie" "Equipment for the Production of Monocrystals und Epi-waters of Callium Arsenide" Reseach and development crystal puller for Ga Ar L.P.Ai Calaxie Type), die eine horizontal liegende Platte, einen auf dieser Platte befestigten Senkrechtständer mit einer Tragsäule, eine Wachstumskammer, die durch ihren Oberteil mittels einer oberen Konsole mit der Tragsäule und durch ihren Unterteil mittels einer unteren Konsole mit dem Ständer starr verbunden ist, enthält sowie in der Kammer angeordnete einen Schmelzentiegel und einen Impfkristallhalter, die entsprechend an einer unteren und an einer oberen Stange befestigt sind, welche derart angeordnet sind, daß sie hin- und hergehende Bewegungen relativ zu dem Gehäuse der Kammer und Drehungen um die eigene Achse ausführen können, einschließt. Die Vorrichtungen zur Bewegung und Drehung der oberen und der unteren Stange sind an der oberen und der unteren Konsole entsprechend montiert.

Die mit Hilfe dieser Vorrichtung gezüchteten Kristalle sind von einer nicht ausreichenden Qualität, zu diesen gehören insbesondere Lithiumniobateinskristalle, die eine erhöhte optische Inhomogenität aufweisen. Die maximale Änderung der Brechungszahl erreicht in diesen Kristallen $\Delta r_c = 5 \cdot 10^{-5}$. Außerdem behalten die Kristalle das Monodomänenverhalten in einem Abstand von nicht höher als 5 bis 10 mm von dem Impfkristall, wonach das Monodomänenwachstum gestört wird.

Wie bekannt ist die Unregelmäßigkeit der Brechungszahl durch eine ungleichmäßige Verteilung des Legierungsverunreinigungsstoffes oder durch eine Verletzung der Kristallstöchiometrie an einzelnen Abschnitten bedingt. Zu den technologiebedingten Hauptfaktoren, die das Entstehen von groben Streifen mit einer ungleichmäßigen Verteilung der Verunreinigungen (der Abstand zwischen den groben Streifen beträgt einige Dutzende bis zu einigen Hunderten Mikrometer) in den im Tiegelziehverfahren nach Czochralski gezüchteten Kristallen hervorrufen, gehören periodische Schwankungen der Schmelzentemperatur. Diese Wärmeschwankungen werden durch eine Konvektion der Schmelze im Tiegel bestimmt, wobei die Schwankungsperiode in der Regel einige Minuten beträgt. (A.Ia. Namelsky "Technologie der Halbleiterstoffe", Verlag "Metallurgi ", Moskau, herausgegeben 1972. Seiten 158 bis 162). Eine andere Ursache, die eine schichtige Unregelmäßigkeit der Verteilung des Verunreinigungsstoffes hervorruft, ist die Verletzung der mechanischen Bedingungen für das Kristallwachstum, zu welchen instabile Geschwindigkeiten des Ziehens und der Drehung des Kristalls, der Bewegung und der Drehung des Tiegels, der Kristallschwingungen gehören. Bei der gemeinsamen Wirkung von zwei Faktoren der Verletzung der mechanischen Wachstumsbedingungen wird der richtige Verlauf der durch die Konvektion hervorgerufenen Wachstumsstreifen verzerrt, wodurch insgesamt die Unregelmäßigkeit der Verteilung des Verunreinigungsstoffes erhöht wird. (A.Ia. Namelsky "Technologie der Halbleiterstoffe", Verlag "Metallurgi ", Moskau, herausgegeben 1972, Seiten 158 bis 162).

Die erhöhte optische Inhomogenität und der schmale Bereich des Monodomänenverhaltens in Kristallen, die mit Hilfe der bekannten Vorrichtung gezüchtet worden sind, sind durch Verletzungen der mechanischen Wachstumsbedingungen während des Kristallisationsvorganges hervorgerufen. Die Wachstumskammer besteht bei der bekannten Vorrichtung aus zwei Teilen, die in vertikaler Richtung trennbar sind. Dabei ist der Unterteil der Kammer mittels der unteren Konsole mit dem Ständer der als Teleskoprohr ausgeführten Tragsäule verbunden, und der Oberteil der Kammer hat ausgedehnte Zusatzkammer, die mittels der oberen Konsole an der als Teleskoprohr ausgeführten Säule befestigt ist. Die Länge der Zusatzkammer übersteigt die Länge der Hauptkammer. Die Dichtung der Stange ist im Oberteil der Zusatzkammer vorgesehen. Bei einem Arbeitshub der Stange ist die Schraube, über welche sich eine Mutter bewegt, mit einem Motor zur beschleunigten Bewegung der Stange verbunden. Deswegen werden durch den Motor zur Arbeitsbewegung die Schraube und gleichzeitig damit der Motor zur beschleunigten Bewegung der Stange durchgedreht. Das erfordert den Einsatz von Motoren mit einer erhöhten Leistung, wodurch Voraussetzungen für das Entstehen von Schwingungen geschaffen werden. Beim Entstehen von Kristallschwingungen trägt die Befestigung der Wachstumskammer mittels der Konsolen dazu nicht bei, daß diese Schwingungen schnell abklingen.

## Offenbarung der Erfindung

Die Erfindung liegt die Aufgabe zugrunde, die Konstruktion einer Vorrichtung zur Züchtung der Einkristalle von hochschmelzenden Metalloxiden aus der Schmelze mit einem solchen Schema der Befestigung der Wachstumskammer zu entwicklen, das ein möglichst schnelles Abklingen der durch Verletzungen der mechanischen Wachstumsbedingungen hervorgerufenen Schwingungen des zu züchtenden Kristalls gewährleistet, was letzten Endes zu einer Erhöhung der optischen Homogenität der zu züchtenden Kristalle führt.

Die gestellte Aufgabe wird dadurch gelöst, daß in einer Vorrichtung zur Züchtung der Einkristalle von hochschmelzenden Metalloxiden aus der Schmelze, die eine horizontal liegende Stützplatte, einen auf dieser Platte befestigten Senkrechtständer mit einer Tragsäule, eine Wachstumskammer, die durch ihren Oberteil mittels einer Konsole mit der Tragsäule starr verbunden ist, sowie in der Kammer angeordnete einen Schmelzentiegel und einen Impfkristallhalter, die entsprechend an einer unteren und an einer oberen Stange befestigt sind, welche derart montiert sind, daß sie hin- und hergehende Bewegungen relativ zu dem Gehäuse der Wachstumskammer und Drehungen um die eigene Achse ausführen können enthält, erfindungsgemäß die Wachstumskammer durch ihren Unterteil mittels einer Stütze mit der Stützplatte starr verbunden ist, wobei der Ständer mit der Tragsäule, die Konsole, die Wachstumskammer, die Stütze und die Stützplatte ein geschlossenes steifes System vom "Rahmen"-Typ bilden.

Es ist zweckmäßig, die Stütze in Form eines Hohlkörpers auszubilden und in diesem eine Vorrichtung zur
hin- und hergehenden Bewegung und zur Drehung der unteren Stange unterzubringen.

Die gemäß der vorliegenden Erfindung ausgeführte
Vorrichtung zur Züchtung der Einkristalle von hochschmelzenden Metalloxiden gestattet es, Einkristalle der hochschmelzenden Metalloxide von einer hohen Qualität herzustellen, u.z. mit einer erhöhten optischen Homogenität
zu gewinnen. Das wird dadurch erzielt, daß ein schnelles
Abklingen der Schwingungen gewährleistet wird, die durch
mechanische Verletzungen des Kristallisationsvorganges
im geschlossenen steifen, durch den Ständer mit der Tragsäule, die Konsole, die Wachstumskammer, die Stütze und
die Stützplatte gebildeten System von "Rahmen"-Typ hervorgerufen werden.

Kurze Beschreibung der Zeichnungen

Nachstehend wird die Erfindung durch die Beschreibung von konkreten Ausführungsvarianten unter Bezugnahme auf die beigefügten Zeichnungen erläutert. Es zeigen:

Fig. 1 - die Gesamtansicht einer Vorrichtung zur
Züchtung der Einkristalle von hochschmelzenden Metalloxiden aus der Schmelze, im Längsschnitt;

Fig. 2 - Vorrichtungen zur hin- und hergehenden Bewegung und zur Drehung einer der Stangen um die eigene
Achse, im Längsschnitt;

Fig. 3 - einen Abschnitt A in Fig. 2, vergrößert;

Fig. 4 - einen Schnitt nach der Linie IV-IV der

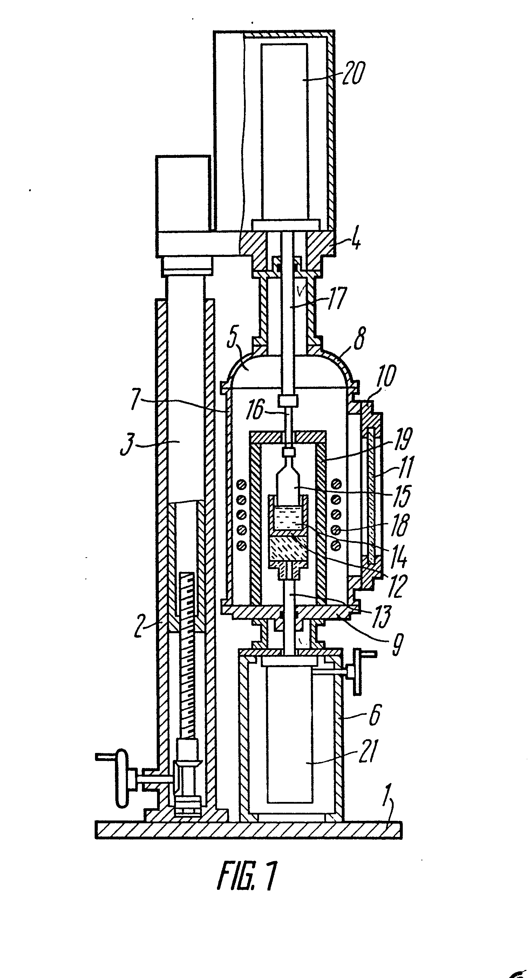

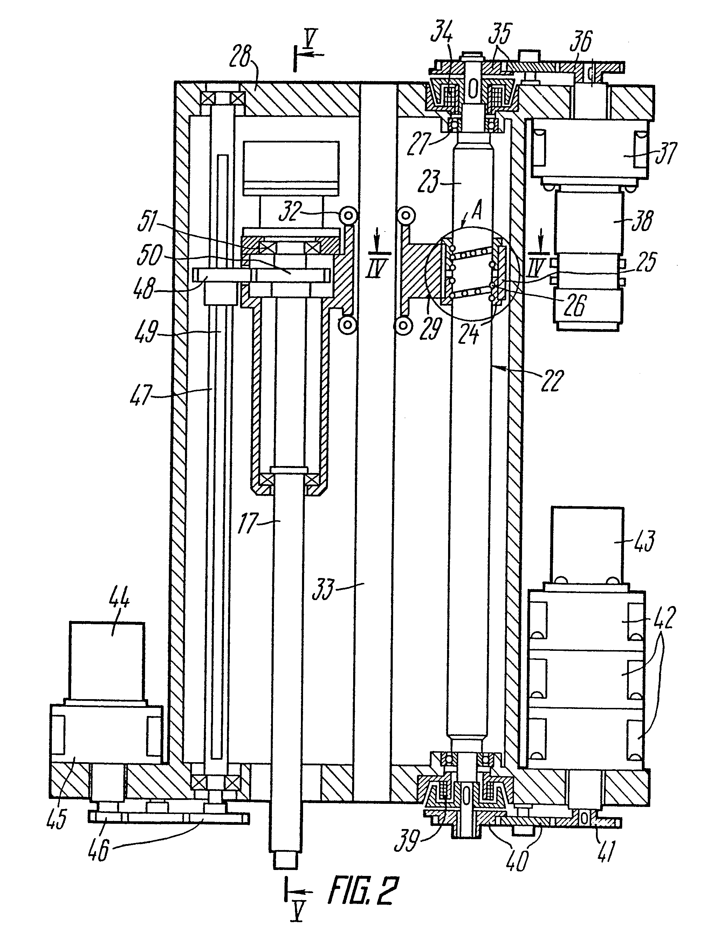

Fig. 2, vergrößert;

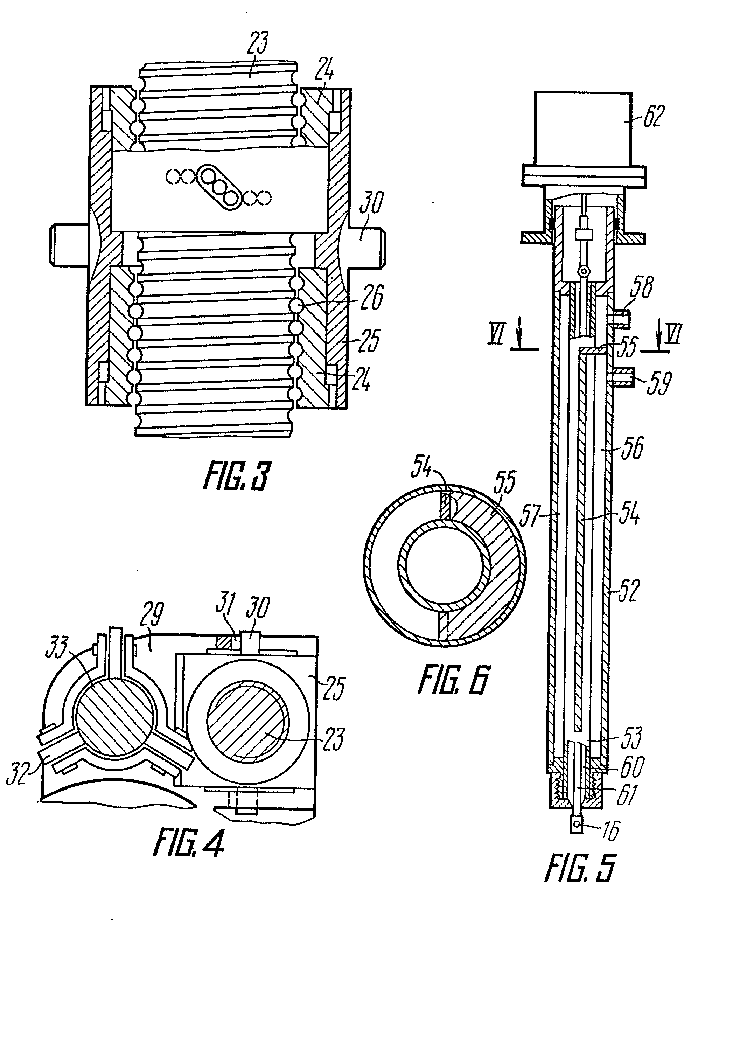

Fig. 5 - einen Schnitt nach der Linie V-V der Fig.2;

Fig. 6 - einen Schnitt nach der Linie VI-VI der
Fig. 5, vergrößert.

Bevorzugte Ausführungsform der Erfindung

Die in Fig. 1 dargestellte Vorrichtung zur Züchtung
der Einkristalle von hochschmelzenden Metalloxiden enthält eine horizontal liegende rechtwinklige Stützplatte 1, auf welcher ein Senkrechtständer 2 mit einer in diesem koaxial angeordneten Tragsäule 3 befestigt ist, eine an der Tragsäule 3 befestigte Konsole 4, eine Wachstumskammer 5 für Kristalle, die durch ihren Oberteil mit der Konsole 4 und durch ihren Unterteil mittels einer Stütze 6 mit der Stützplatte 1 starr verbunden ist. Dabei bilden die Stützplatte 1, der Senkrechtständer 2, die Tragsäule 3, die Konsole 4, die Wachstumskammer 5, die Stütze 6 ein geschlossenes steifes System vom "Rahmen"-Typ.

Innerhalb der Wachstumskammer 5, die aus einem zylinderförmigen Gehäuse 7, einem oberen Deckel 8, einem Boden 9 und einer Tür 10 mit einem Beobachtungsfenster 11 besteht, ist ein Schmelzentiegel 12 angeordnet, der an einer unteren Stange 13 angebracht ist. Im Tiegel 12 befindet sich ein Gemengesatz 14, aus dessen Schmelze ein Kristall 15 gezüchtet wird, der an einem Impfkristallhalter 16 befestigt ist, welcher mit einer oberen Stange 17 starr verbunden ist. Die Stangen 13 und 17 sind derart angeordnet, daß sie hin - und hergehende Bewegungen relativ zu dem Gehäuse der Kammer 5 und Drehungen um die eigene Achse ausführen können. In der Wachstumskammer 5 ist ein Induktor 18 untergebracht, der als Heizquelle für den Tiegel 12 mit dem Gemengesatz 14 dient, und koaxial mit dem Tiegel 12 liegt, der durch einen keramischen Isolationsschirm 19 vom Induktor 18 isoliert ist. Die obere Stange 17 ist mit einer Vorrichtung 20 zur hin- und hergehenden Bewegung und zur Drehung derselben versehen, die an der Konsole 4 montiert ist. Die untere Stange 13 ist mit einer der Vorrichtung 20 ähnlichen Vorrichtung 21 zur hin- und hergehenden Bewegung und zur Drehung versehen, die sich innerhalb der Stütze 6 befindet, welche zu diesem Zweck in Form eines Hohlkörpers ausgebildet ist.

Fig. 2, 3, 4 veranschaulichen eine der möglichen Ausführungsformen der Vorrichtung 20 zur hin- und hergehenden Bewegung und zur Drehung der Stange 17. Die Vorrichtung 21 hat eine ähnliche Ausführungsform.

Die Vorrichtung 20 enthält ein Schrauben-Kugelpaar 22, das aus einer Bewegungsschraube 23, zwei Muttern 24, die in einer Hülse 25 untergebracht sind, und aus zwischen der Schraube 23 und den Muttern 24 befindlichen Kugeln 26 besteht.

Die Schraube 23 ist in Lagern 27 eines Gehäuses 28 gelagert. Die Hülse 25 ist in einem Schlitten 29 montiert und mit diesem mittels Bolzen 30 verbunden, die sich in Nuten 31 des Schlitzens 29 befinden. Dabei haben die Nuten 31 einen Durchmesser, der den Durchmesser der Bolzen 30 übersteigt, um eine zügige Verschiebung der Hülse 25 mit den Muttern 24 relativ zu dem Schlitten 29 zu ermöglichen. Der Schlitten 29 ist mit Rollen 32 versehen, die über eine vertikale im Gehäuse befestigte Stütze 33 fahren können. An einem der Enden der Bewegungsschraube 23 ist eine Elektromagnetkupplung 34 vorgesehen, die über Zahnräder 35, 36 und ein Getriebe 37 das Drehmoment von einem Motor 38 auf die Bewegungsschraube 23 im Betriebszustand der beschleunigten Bewegung der Stange 17 überträgt.

An dem anderen Ende der Bewegungsschraube 23 ist eine Elektromagnetkupplung 39 angeordnet, die die Bewegungsschraube 23 über Zahnräder 40, 41 und ein Getriebe 42 mit der Antriebswelle eines Motors 43 im Betriebszustand der Arbeitsbewegung der Stange 17 verbindet. Das Getriebe 42 ist in Form eines Satzes von einzelnen Moduln ausgebildet, die es gestatten, das Übersetzungsverhältnis des Getriebes 42 in einem breiten Bereich durch einen folgerichtigen Anschluß der Moduln in Abhängigkeit von dem gewünschten Betriebszustand der Kristallzüchtung zu ändern. Die Drehung der Stange 17 wird mittels eines Elektromotors 44 verwirklicht, der über ein Getriebe 45 und Zahnräder 46 mit einer Welle 47 verbunden ist, an welcher ein Zahnrad 48 über eine der Länge der Welle 47 nach ausgeführte Nut 49 fahrbar angeordnet ist. Das Zahnrad 48 steht in Verzahnung mit einem Zahnrad 50, das an der Stange 17 starr befestigt ist. Das Ende der Stange 17 ist in einem Lager 51 gelagert, dessen Hülse im Schlitten 29 befestigt ist.

In Fig. 5, 6 ist die Konstruktion einer der Stangen 13, 17 wiedergegeben, von denen jede aus zwei koaxialen Rohren 52, 53 besteht, wobei der Zwischenraum zwischen diesen Rohren in Achsialrichtung durch zwei Scheidewände 54 und in radialer Richtung durch einen Halbring 55 getrennt ist. Dadurch werden zwei im Unterteil der Stange 17 (13) miteinander in Verbindung stehende Hohlräume 56, 57 gebildet, wobei oberhalb des Halbringes 55 ein Stutzen 58 zum Zuführen eines Kühlmittels in den Hohlraum 57 und unterhalb des Halbringes 55 ein Stutzen 59 zum Abführen des Kühlmittels angeordnet sind. Durch den Hohlraum 60 des Rohres 53 ist eine Zugstange 61 geführt, die durch das eine Ende mit dem Fühler eines Waagegebers 62 und durch das andere Ende mit dem Inpfkristallhalter 16 verbunden ist.

Die erfindungsgemäße Vorrichtung zur Züchtung der Einkristalle von hochschmelzenden Metalloxiden aus der Schmelze hat folgende Wirkungsweise.

Durch den Induktor 18, die Stangen 13, 17 und das System zum Abkühlen der Kammer 5 wird Kühlwasser geleitet. Der Tiegel 12 mit dem Gemengesatz 14 wird an der unteren Stange 13 angebracht. Dem Induktor 18 wird eine Hochfrequenzspannung zugeführt. Die Spannung wird solange erhöht, bis der Gemengesatz 14 im Tiegel 12 geschmolzen ist. Man schaltet den Elektromotor 38 zur beschleunigten Bewegung des Impfkristalls ein. Über das Getriebe 37, die Zahnräder 35 und die Elektromagnetkupplung 34 wird eine Drehung vom Motor 38 auf die Schraube 23 übertragen, auf welche die Muttern 24 aufgeschraubt werden, wodurch die Hülse 25 und der Schlitten 29 nach unten bewegt werden. Die sich in den Nuten 31 verschiebenden Bolzen 30 dämpfen dabei die beim Betrieb der Vorrichtung entstehenden Schwingungen. Der Schlitten 29 rollt auf den Rollen 32 über die Führungsstütze 33, indem er die Stange 17 nach unten bewegt. Nachdem der Impfkristall die Lage erreicht hat, wo er einige Millimeter vom Schmelzenstand entfernt ist, wird der Motor 38 abgeschaltet.

Man schaltet den Motor 44 ein, der über das Getriebe 45 und die Zahnräder 46 die Welle 47 in Drehung versetzt, die ihrerseits ein über die Schlitznur 49 gleitendes Zahnrad 48 dreht, das die Stange 17 über ein Zahnrad 50 in Drehung versetzt. Dann wird die Elektromagnetkupplung 34 abgeschaltet, wobei die Schraube 23 von dem Elektromotor 38 abgekuppelt wird. Man schaltet die Elektromagnetkupplung 39 ein, indem man die Schraube 23 mit dem Elektromotor 43 verbindet. Man schaltet den Elektromotor 43 ein und bewegt die Stange 17 bis zum Eintauchen des Impfkristalls in die Schmelze. Dann wird die Stange 17 mittels des Elektromotors 43 hochgehoben, und man beginnt mit der Züchtung des Kristalls 15. Der Kristall 15 überträgt über die Zugstange 61 (Fig. 5) eine Kraft auf den Waagegeber 62. Dabei wird ein Signal vom Waagegeber 62 einer EDV-Anlage zugeführt (in Fig. nicht wiedergegeben). Das Signal des Waagegebers 62 dient als Referenzsignal zur Steuerung des Prozesses. Je nach der Verarbeitung der Schmelze werden die Bewegung und Drehung des Tiegels 12 (Fig. 1) durch die Bewegung und Drehung der Stange 13 mittels der Vorrichtung 21 verwirklicht, die der Vorrichtung 20 zur Bewegung und zur Drehung der oberen Stange 17 ähnlich ist.

Beim Betrieb der Anlage fließt das Kühlwasser in den Stutzen 58 der Stange 13 (17), wonach es über eine Hohlraum, der durch vertikale Scheidewände 54 zwischen dem Außenrohr und dem Innenrohr 52, 53 abgetrennt ist, bis zum Boden der Stange gelangt, in einen anderen zwischen dem Außenrohr und dem Innenrohr 52, 53 gebildeten Hohlraum überfließt und in den Stutzen 59 austritt.

Die erfindungsgemäße Vorrichtung zur Züchtung der Einkristalle, bestehend aus der Stützplatte 1, dem Senkrechtständer 2, der Tragsäule 3, der Konsole 4, der Wachstumskammer 5, der Stütze 6, die ein geschlossenes steifes System vom "Rahmen"-Typ bilden, wodurch Bedingungen für eine Verminderung der Übertragung der Schwingungen auf den Kristall 15 von den Vorrichtungen 20, 21 zur Bewegung der unteren und der oberen Stange 17, 13 geschaffen werden, gestattet es, Einkristalle mit verbesserten optischen Eigenschaften herzustellen. Durch das Vorhandensein von zwei Elektromagnetkupplungen 34, 39 bei der Schraube 23 des Schrauben-Kugelpaares 22 wurde es möglich, im Unterschied zu der bekannten Vorrichtung beim Ziehen eines Kristalls die Schraube 23 vom Elektromotor 33 abzukuppeln und auf diese Weise die Belastung (und auch die Leistung) des Motors zur Arbeitsbewegung zu vermindern. Einen bestimmten Beitrag zur Beseitigung der mechanischen Störungen des Kristallisationsvorganges leistet auch die Konstruktion der Mutter des Schrauben-Kugelpaares 22, die als zwei Muttern 24 ausgeführt ist, welche relativ zueinander mit einem Moment M-5-8 km-cm festgezogen werden. Die Muttern 24 befinden sich in der Hülse 25 (Fig. 4), die mit zwei koaxialen Halbachsen 30 in der durch die Achse der Schraube 23 und die Achse des Schlittens 29 gelegenen Horizontalebene versehen ist. Dadurch wird eine Bewegung des Schlittens 29 zur Selbsteinstellung ermöglicht.

Da die Stange 13 (17) aus zwei koaxialen Rohren 52, 53 besteht, die durch über einen Halbring 55 verbundene längsverlaufende Scheidewände 54 getrennt sind, erfolgt die Abkühlung der Stange 13 (17) durch die Zuführung des Wassers in eine der Längskammern, aus welcher das Wasser bis zum Impfkristallhalter herunterfließt, wonach es in einer anderen Längskammer hochsteigt und in den Austrittsstutzen 59 austritt. Eine solche Konstruktion gewährleistet eine wirksame Abkühlung der Stange 13 (17) und gestattet es, deren Durchmesser zu vermindern, wodurch seinerseits die Belastung des Motors zur Arbeitsbewegung reduziert wird. Dabei wird die Möglichkeit einer Entstehung von Schwingungen einzelner Teile der Anlage vermindert.

Die erfindungsgemäße Vorrichtung gestattet es, Kristalle von hochschmelzenden Metalloxiden von einer hohen Qualität durch eine starke Verminderung der durch die Apparatur bedingten "lineagen" Struktur der Kristalle und durch eine Reduzierung der Domänenzahl herzustel-

0253950

len. Die lokalen Unregelmäßigkeiten der Brechungszahl auf Wachstumsstreifen vermindern sich, z.B. in Lithiumniobat-Einkristallen um ein 5 bis 8faches und die Länge des Monodomänenteils dieser Kristalle nimmt um ein 4 bis 6faches zu.

## Industrielle Anwendbarkeit

Die Vorrichtung zur Züchtung der Einkristalle von hochschmelzenden Metalloxiden aus der Schmelze kann zur Züchtung der Einkristalle von Lithiumniobat, Lithiumtantalat, Yttriumtongranat, Saphir, Rubin und anderen Stoffen verwendet werden.

PATENTANSPRÜCHE

1. Vorrichtung zur Züchtung der Einkristalle von hochschmelzenden Metalloxiden aus der Schmelze, die eine horizontal liegende Stützplatte (1), einen auf dieser Platte befestigten Senkrechtständer (2) mit einer Tragsäule (3), eine Wachstumskammer (5), die durch ihren Oberteil mittels einer Konsole (4) mit der Tragsäule (3) starr verbunden ist, sowie in der Kammer (5) angeordnete einen Schmelzentiegel (12) und einen Impfkristallhalter (16), die entsprechend an einer unteren und an einer oberen Stange (13, 17) befestigt sind, von denen jede derart angeordnet ist, daß sie hin- und hergehende Bewegungen relativ zu dem Gehäuse der Wachstumskammer (5) und Drehungen um die eigene Achse ausführen kann, dadurch gekennzeichnet, daß die Wachstumskammer (5) durch ihren Unterteil mittels einer Stütze (6) mit der Stützplatte (1) starr verbunden ist, wobei der Ständer (2) mit der Tragsäule (3), die Konsole (4), die Wachstumskammer (5), die Stütze (6) und die Stützplatte (1) ein geschlossenes steifes System vom "Rahmen"-Typ bilden.

2. Vorrichtung zur Züchtung der Einkristalle nach Anspruch 1, dadurch gekennzeichnet, daß die Stütze (6) in Form eines Hohlkörpers ausgebildet ist und in diesem eine Vorrichtung (21) zur hin- und hergehenden Bewegung und zur Drehung der unteren Stange (13) untergebracht ist.

FIG. 1

*FIG. 2*

0233950

FIG. 3

FIG. 4

FIG. 6

FIG. 5

**I. CLASSIFICATION OF SUBJECT MATTER** (if several classification symbols apply, indicate all) *

According to International Patent Classification (IPC) or to both National Classification and IPC

IPC$^4$- C 30 B 15/30, 15/00

**II. FIELDS SEARCHED**

| Minimum Documentation Searched † | |
|---|---|
| Classification System | Classification Symbols |
| IPC$^4$<br>US | C 30 B 15/00, 15/30<br>156/618, 156/619, 422/249 |

Documentation Searched other than Minimum Documentation
to the Extent that such Documents are Included in the Fields Searched *

**III. DOCUMENTS CONSIDERED TO BE RELEVANT** *

| Category * | Citation of Document, 11 with indication, where appropriate, of the relevant passages 12 | Relevant to Claim No. 13 |
|---|---|---|
| A | US, A, 3359077 , (Globe – Union Inc.) .<br>19 December 1967 (19.12.67), see figure 1 | 1 |
| A | US, A, 4302280 (Texas Instruments Incorpora-<br>ted) 24 November 1981 (24.11.81)see figure 1 | 2 |
| A, P | US, A, 4600564 (Crismatec, Gieres),<br>15 July 1986 (15.07.86), see figures 1-3,<br>the claims | 2 |

* Special categories of cited documents: 10

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art.

"&" document member of the same patent family

**IV. CERTIFICATION**

| Date of the Actual Completion of the International Search | Date of Mailing of this International Search Report |
|---|---|
| 10 November 1986 (10.11.86) | 02 December 1986 (02.12.86) |
| International Searching Authority | Signature of Authorized Officer |
| ISA/SU | |

Form PCT/ISA/210 (second sheet) (January 1985)